# EUROPÄISCHE PATENTSCHRIFT

(11) **EP 0 866 979 B1**
(45) Veröffentlichungstag und Bekanntmachung des Hinweises auf die Patenterteilung: **03.04.2002**
(21) Anmeldenummer: 96946076.5
(22) Anmeldetag: 12.12.1996
(51) Int. Cl.: G01R 31/36

(54) **VERFAHREN ZUM ANZEIGEN DES ZUSTANDS "ENERGIESPEICHER ERSCHÖPFT" IN ELEKTRO-GERÄTEN MIT ELEKTRO-ENERGIESPEICHERN UND ELEKTRO-GERÄTE MIT ELEKTRO-ENERGIESPEICHERN ZUM ANZEIGEN DES ZUSTANDS "ENERGIESPEICHER ERSCHÖPFT"**
METHOD FOR DISPLAYING A "LOW BATTERY" STATE IN ELECTRICAL EQUIPMENT WITH ELECTRICAL ENERGY STORES AND ELECTRICAL EQUIPMENT WITH ELECTRICAL ENERGY STORES WITH MEANS FOR DISPLAYING A "LOW BATTERY" STATE
PROCEDE D'INDICATION DE L'ETAT "ACCUMULATEURS D'ENERGIE FAIBLES" DANS DES APPAREILS ELECTRIQUES POURVUS D'ACCUMULATEURS D'ENERGIE ELECTRIQUES, ET APPAREILS ELECTRIQUES POURVUS D'ACCUMULATEURS D'ENERGIE ELECTRIQUES AVEC MOYENS D'AFFICHAGE D'UN ETAT "ACCUMULATEURS FAIBLES"

(30) Priorität: 15.12.1995 DE 19547019
(43) Veröffentlichungstag der Anmeldung: 30.09.1998
(73) Patentinhaber: SIEMENS AKTIENGESELLSCHAFT, 80333 München (DE)
(72) Erfinder: KAMPERSCHROER, Erich, D-46499 Dingden (DE)
(86) Internationale Anmeldenummer: DE9602396
(87) Internationale Veröffentlichungsnummer: WO9722887

(56) Entgegenhaltungen:
- EP-A- 0 555 012
- EP-A- 0 566 264
- DE-C- 4 236 811
- US-A- 5 166 623
- US-A- 5 432 452

## Beschreibung

Elektro-Geräte mit Elektro-Energiespeichern (z.B. Batterien oder Akkumulatoren) und Mitteln zum Anzeigen des Zustands "Energiespeicher erschöpft" (z.B. Display, Klingel etc.) sind beispielsweise mobile Telekommunikationsgeräte (Funkgeräte), die auf dem Frequenz- und/oder Zeitmultiplexverfahren oder dem Codemultiplexverfahren basieren und über Akkumulatoren oder Batterien mit elektrischer Energie versorgt werden.

So gibt es beispielsweise Schnurlos-Mobilteile nach dem DECT/GAP-Standard (**D**igital **E**uropean **C**ordless **T**elecommunication; vgl. **(1):** Nachrichtentechnik Elektronik 42 (1992), Jan./Feb., Nr. 1, Berlin, DE; U. Pilger: "Struktur des DECT-Standards", Seiten 23 bis 29; (**2**): Philips Telecommunication Review, Vol. 49, Nr. 3, Sept. 1991; R. Mulder: "DECT-Universal Cordless Access System", Seiten 68 bis 73 / **G**eneric **A**ccess **P**rofile; vgl. ETSI-Publikation prETS 300 444, April 1995, Final Draft, ETSI, FR) oder Mobilfunk-Mobilteile nach dem GSM-Standard (**G**roupe **S**péciale **M**obile oder **G**lobal **S**ystem for **M**obile Communication; vgl. Informatik Spektrum 14 (1991) Juni, Nr. 3, Berlin, DE; A. Mann: "Der GSM-Standard - Grundlage für digitale europäische Mobilfunknetze", Seiten 137 bis 152).

Figur 1 zeigt ausgehend von der Druckschrift Components 31 (1993), Heft 6, Seiten 215 bis 218; S. Althammer, D. Brückmann: "Hochoptimierte IC's für DECT-Schnurlostelefone" den prinzipiellen Schaltungsaufbau eines z. B. in dem Siemens-Schnurlostelefon "Gigaset 951/952" (vgl. telcom report 16 (1993), Heft 1, Seiten 26 und 27) verwendeten Schnurlos-Mobilteils MT.

Der Schaltungsaufbau besteht aus einem Funkteil FKT, einer Signalverarbeitungseinrichtung SVE mit einem als Burst Mode Controller BMC ausgebildeten Signalsteuerungsteil SST und einem als Codec und AD/DA-Wandler ausgebildeten Signalumformungsteil SUT, einem Taktgenerator TG, einer als Mikrocontroller µc ausgebildeten Zentrale Steuerung ZS, einer BOF-Schnittstelle BSS zu einer Bedienoberfläche BOF mit einer Tastatur TA, einer Anzeigeeinrichtung AE, einer Hörkapsel HK, einem Mikrofon MF und einer Tonrufklingel TRK sowie einer Stromversorgung SV mit einem Akkumulator (Akku) AKK, die in der dargestellten Weise miteinander verbunden sind. Die prinzipielle Funktionsweise des Schaltungsaufbaus ist beispielsweise in der vorstehend zitierten Druckschrift Components 31 (1993), Heft 6, Seiten 215 bis 218 beschrieben.

Statt des Akkumulators AKK ist es auch möglich, eine Batterie als Energiespeicher für das Schnurlos-Mobilteil MT zu verwenden. Diese Batterie wird bei Erschöpfung der gespeicherten Energie im Unterschied zum an der Ladestation LST regenerierbaren Akkumulator durch eine neue Batterie ausgetauscht.

Zum Aufladen des Akkumulators AKK bildet das Mobilteil MT mit einer Ladestation LST eine Funktionseinheit derart, daß der Akkumulator AKK des Mobilteils MT z.B. gemäß dem aus der WO94/10782 bekannten Verfahren aufgeladen wird.

Ist das Mobilteil MT - nach einer solchen Aufladung - über einen längeren Zeitraum in Betrieb gewesen und ist infolgedessen die Kapazität des Akkumulators AKK nahezu erschöpft, so wird - wie bei akkubetriebenen elektrischen Geräten allgemein üblich - der Zustand "Akkumulator erschöpft (Low Bat)" angezeigt. Die Anzeige kann dabei optisch durch das Darstellen eines Akkumulator-Symbols auf der Anzeigeeinrichtung (Display) AE des Mobilteils MT und/oder akustisch durch das Abgeben eines Hinweistons über die Tonrufklingel TRK des Mobilteils MT erreicht werden. Sowohl die Darstellung des Akkumulator-Symbols als auch die Abgabe des Hinweistons sollte für den Benutzer des Mobilteils MT dabei so rechtzeitig erfolgen, daß das Mobilteil bis zum Erreichen des Zustandes "Akkumulator leer" noch eine Restbetriebszeit aufweist, die der Benutzer des Mobilteils MT gegebenenfalls für die Nachrichtenübertragung (z. B. Weiterführen eines Telefongesprächs, obwohl der Zustand "Akkumulator erschöpft (Low Bat)" angezeigt ist) nutzen kann. Andererseits darf sowohl die Anzeige des Akkumulator-Symbols als auch die Abgabe des Hinweistons nicht zu früh erfolgen, weil diese verfrühte Anzeige von dem Benutzer des Mobilteils MT bezüglich der Gesamtbetriebszeit (z. B. Gesamtgesprächszeit) des Mobilteils mißinterpretiert werden kann. Man ist deshalb bestrebt, eine genau bemessene, für den Benutzer akzeptable Restbetriebszeit des Mobilteils MT (z. B. 10 Minuten) einzuhalten.

Um die vorstehend genannten Anforderungen zu erfüllen, ist es -z.B. beim Gigaset 951/952 - bekannt, daß, wenn die von dem Akkumulator AKK gelieferte Akkumulatorspannung einen Wert von z.B. 1,15 V für eine vorgegebene Zeit unterschreitet, der Zustand "Akkumulator erschöpft" angezeigt wird. Die Unterschreitung des Spannungswertes (1,15 V) für die vorgegebene Zeit wird durch einen Spannungsbereich definiert.

Diese Vorgehensweise ist bei Mobilteilen, in denen mehrere Akkumulatoren AKK, sogenannte Akkupacks, verwendet werden, aufgrund der in bezug auf die Akkumulatorspannung engtolerierten Werte der Akkupacks ausreichend.

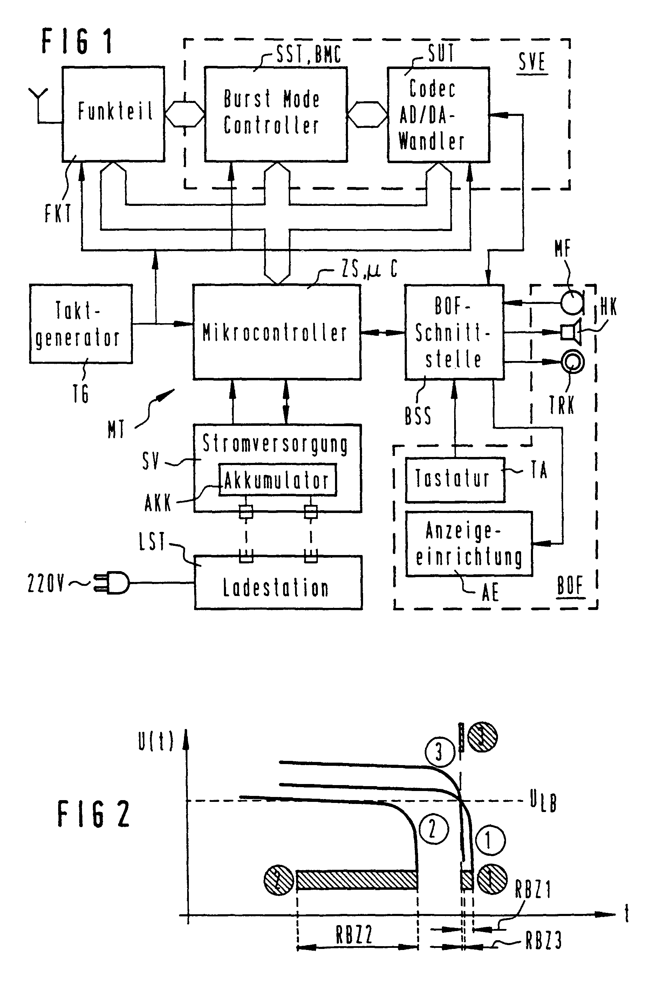

Werden jedoch handelsübliche Mignon-Akkumulatoren in das Mobilteil eingesetzt, so reicht es nicht mehr aus, daß, wenn die von dem Mignon-Akkumulator gelieferte Akkumulatorspannung einen vorgegebenen Wert U_{LB} (U_{**L**ow **B**at} = Spannungswert U, bei dem der Zustand "Akkumulator erschöpft (Low Bat)" angezeigt wird) mit einem U_{LB}-Spannungsbereich (Unterschreitung des Spannungswertes U_{LB} für eine vorgegebene Zeit) unterschreitet, der Zustand "Mignon-Akkumulator erschöpft" angezeigt wird. Dieser Sachverhalt wird anhand der FIG 2 erläutert.

FIG 2 zeigt drei Entladespannungsverläufe ①, ②, ③von Mignon-Akkumulatoren verschiedener Hersteller und drei zu den Entladespannungsverläufen ①, ②, ③gehörende schraffierte Flächen 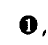 , 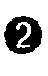 , 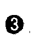 . Die schraffierten Flächen 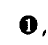 , 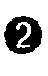 , 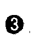 stellen Restbetriebszeiten (z.B. Restgesprächszeiten), eine erste Restbetriebszeit RBZ1, eine zweite Restbetriebszeit RBZ2 und eine dritte Restbetriebszeit RBZ3, der Mignon-Akkumulatoren nach der Erkennung (Anzeige) des Zustands "Akkumulator erschöpft (Low Bat)" dar. Die erste Restbetriebszeit RBZ1 ist z.B. optimal (genaue Bemessung und Akzeptanz des Benutzers) für den Akkumulatortyp ① eingestellt (der U_{LB}-Spannungsbereich wird zeitlich optimal durchfahren). Die zweite Restbetriebszeit RBZ2 ist zu lang, weil aufgrund der niedrigeren Spannungslage des Akkumulatortyps ② der U_{LB}-Spannungsbereich zu langsam durchfahren wird. Die dritte Restbetriebszeit RBZ3 ist zu kurz, weil aufgrund der höheren Spannungslage des Akkumulatortyps ③ der U_{LB}-Spannungsbereich zu schnell durchfahren wird.

Der gleiche Effekt tritt auf, wenn ein Paket von Akkumulatoren (Akkupack) bei unterschiedlichen Umgebungstemperaturen entladen wird, weil die Spannungslage sehr stark von der Temperatur abhängt.

Aus der EP-0 555 012 A2 ist ein Verfahren zum Anzeigen der Entladung von Energiespeichern (z. B. Batterien oder Akkumulatoren) bekannt, bei dem es darum geht, die im Energiespeicher insgesamt nutzbare Energie bis zum Unterbrechen der Versorgungsverbindung zwischen dem Energiespeicher und dem zu versorgenden elektrischen Gerät zu maximieren (Minimierung der verbleibenden Restenergie). Bei den Energiespeichern kann es sich z. B. um Lithium-, Nickelcadmium- oder Metallhybrid-Energiespeicher handeln. Für die Anzeige der Entladung des Energiespeichers wird der Ladungszustand bestimmt, der sich aus der Änderung der Energiespeicherspannung über die Zeit (Berechnung der Steigung dv/dt) ergibt. Zusätzlich ist es noch möglich, die Änderung der Steigung über die Zeit [Berechnung der Krümmung d/dt(dv/dt)] zu ermitteln.

Aus der US-5,166,623 ist ein Verfahren zum Anzeigen des Entladungszustandes von Energiespeichern (Batterien) bekannt, bei dem während der Entladephase des Energiespeichers zu vorgegebenen Zeitpunkten jeweils eine die Steigung einer Entladekurve des Energiespeichers angebende Kenngröße in Form eines steigungsbezogenen Ist-Wertes ermittelt wird. Im Anschluß daran werden die auf diese Weise ermittelten Steigungen miteinander verglichen. In Abhängigkeit von diesem Vergleichsergebnis werden die Zustände "USED", "EMPTY" und "FULL" angezeigt, wobei der mit dem Zustand "Energiespeicher erschöpft" vergleichbare Zustand "EMPTY" dann angezeigt wird, wenn ein ermittelter Steigungswert größer ist als ein zuvor ermittelter Steigungswert bzw. wenn die Steigung gestiegen ist.

Aus der US-5,432,452 bzw. der EP-0 582 527 A1 ist eine Vorrichtung zur Erkennung des Ausfalls von Elementen einer Batterie bekannt, in der die zweite Ableitung der Entladespannungskurve der Batterie mit einem Schwellwert verglichen wird. Wird dieser vorgegebene Schwellwert überschritten, so kommt es zur Anzeige "Ausfall von Elementen der Batterie liegt vor".

Die der Erfindung zugrundeliegende Aufgabe besteht darin, bei Elektro-Geräten mit einem Speicher zum Speichern elektrischer Energie (Elektro-Energiespeicher) den Zustand "Energiespeicher erschöpft" im Interesse einer optimalen sowie für diverse Energiespeichertypen und unterschiedliche Betriebsbedingungen des Energiespeichers einheitlichen Ausnutzung der gespeicherten Energie weder zu früh noch zu spät anzuzeigen.

Diese Aufgabe wird durch die Merkmale des Patentanspruches 1 und durch die Merkmale des Patentanspruches 7 gelöst.

Die der Erfindung zugrundeliegende Idee besteht darin, daß in einem Elektro-Gerät, z.B. einem Schnurlos-Mobilteil, mit einem Elektro-Energiespeicher, z.B. einem Akkumulator oder einer Batterie, der Zustand "Energiespeicher erschöpft" durch das - z.B. kontinuierliche (Anspruch 2 bzw. Anspruch 9) - Berechnen der Krümmung des Entladespannungsverlaufes des Energiespeichers mittels linearer Regression in Form eines die Krümmung angebenden Istwertes in der Entladephase des Energiespeichers und durch das Vergleichen des Istwertes mit einem Sollwert weder zu früh noch zu spät angezeigt wird. Auf diese Weise ist gewährleistet, daß, unabhängig vom Typ des Energeispeichers, der Spannungslage und der Umgebungstemperatur, der Energeispeicher (z.B. der Akkumulator) bzw. das Elektro-Gerät (z.B. das Schnurlos-Mobilteil) annähernd immer eine gleiche Restbetriebszeit aufweist. Außerdem ist eine genaue Kenntnis des Entladespannungsverlaufes des in dem Gerät verwendeten Energiespeichers nicht erforderlich.

Das Berechnen und Vergleichen erfolgt in einem Mikrocontroller des Elektro-Gerätes vorzugsweise softwaregestützt. Eine Hardware-Realisierung ist aber auch möglich.

Bei der Berechnung wird die Tatsache ausgenutzt, daß die Krümmung im "Spannungsknie" einer Entladespannungskurve des Energiespeichers unabhängig von der jeweiligen Spannungslage des Entladespannungsverlaufes immer gleich ist.

Um die Berechnung nicht über einen längeren Zeitraum durchführen zu müssen, wird diese gemäß Anspruch 3 bzw. 10 erst dann gestartet, wenn ein vorgegebener Spannungswert der Entladespannungskurve unterschritten worden ist.

Vorteilhafte Weiterbildungen der Erfindung sind in den Unteransprüchen angegeben.

Ein Ausführungsbeispiel der Erfindung wird anhand der Figuren 3 bis 5 erläutert. Es zeigen:
FIG 3 ausgehend von FIG 1 ein modifiziertes, erweitertes Schnurlos-Mobilteil mit Mitteln zum Erkennen des Zustands "Akkumulator erschöpft",
FIG 4 den Aufbau der Erkennungsmittel nach FIG 3,
FIG 5 einen Entladespannungsverlauf des Akkumulators nach FIG 3.

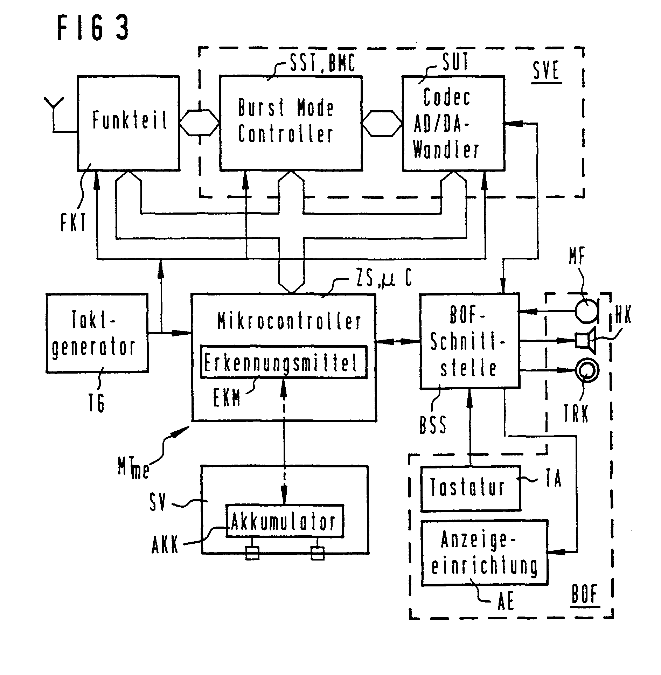

FIG 3 zeigt ausgehend von dem Schnurlos-Mobilteil MT nach FIG 1 ein modifiziertes, erweiteres Schnurlos-Mobilteil MTₘₑ, das zum Erkennen des Zustands "Akkumulator erschöpft" Erkennungsmittel EKM aufweist. Die Erkennungsmittel EKM sind in der zentralen Steuerung ZS enthalten und über die Verbindung zwischen der Zentralen Steuerung ZS und der Stromversorgung SV mit dem Akkumulator AKK bidirektional verbunden.

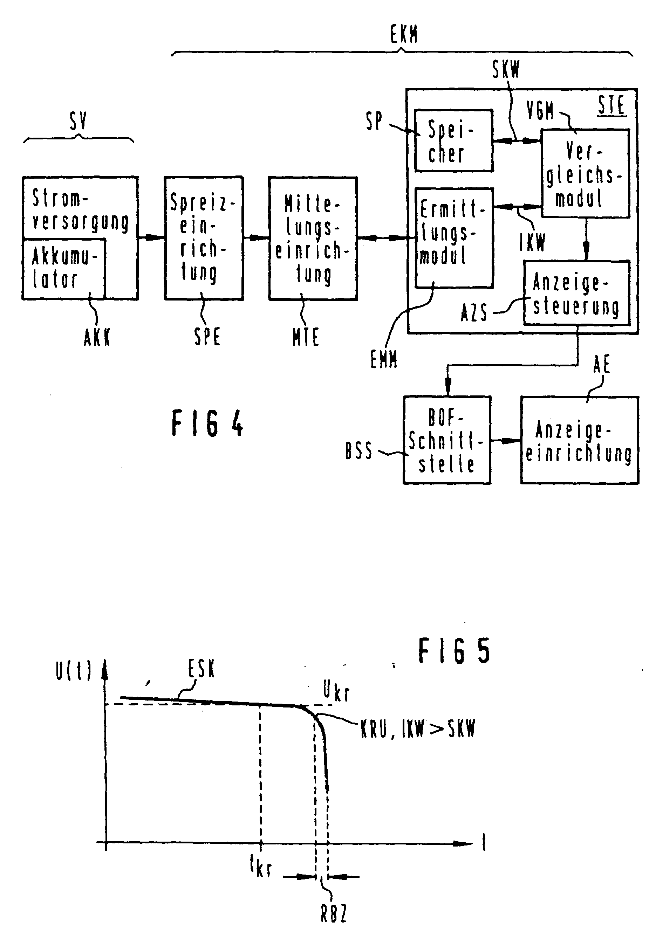

FIG 4 zeigt den Aufbau der Erkennungsmittel EKM nach FIG 3. Die Erkennungsmittel EKM umfassen dabei ein der Stromversorgung SV nachgeschaltete Spreizeinrichtung SPE (Level Shifter), eine der Spreizeinrichtung SPE nachgeschaltete Mittelungseinrichtung MTE und eine der Mittelungseinrichtung MTE nachgeschaltete Steuerungseinrichtung STE. In der Steuerungseinrichtung STE findet die eigentliche Erkennung des Zustands "Akkumulator erschöpft" statt. Die Steuerungseinrichtung STE weist dazu ein Ermittlungsmodul EMM, ein Vergleichsmodul VGM, einen Speicher SP und eine Anzeigesteuerung AZS auf. Die Funktionsweise der Erkennungsmittel EKM wird im Zusammenhang mit der FIG 5 erläutert.

FIG 5 zeigt ausgehend von FIG 2 eine Entladespannunungskurve ESK des Akkumulators AKK.

Zur Erkennung des Zustands "Akkumulator erschöpft" wird das Charakteristikum ausgenutzt, daß die Krümmung im "Spannungsknie" der Entladespannungskurven nach FIG 2 und 5 unabhängig von der jeweiligen Spannungslage des Entladespannungsverlaufes immer gleich ist. Dabei werden in den Entladephasen der Akkumulatoren ständig (kontinuierlich) aktuelle (momentane) Krümmungen KRU der Entladespannungskurven (Kenngrößen der Entladespannungskurven) berechnet. Die Berechnung erfolgt dabei beispielsweise mittels linearer Regression. Überschreitet/Unterschreitet die berechnete Krümmung einen definierten negativen/positiven Wert, so wird der Zustand "Akkumulator erschöpft" gemeldet. Auf diese Weise ist gewährleistet, daß, unabhängig vom Typ des Akkumulators und der Umgebungstemperatur, der Akkumulator annähernd immer eine gleiche Restbetriebszeit aufweist.

Die kontinuierliche auf der linearen Regression gestützte Berechnung der Krümmung KRU der Entladespannungskurve ESK des Akkumulators AKK durch die Erkennungsmittel EKM sieht im Detail folgendermaßen aus:

Wenn zu einem Zeitpunkt tₖᵣ der Entladephase ein Spannungswert Uₖᵣ unterschritten wird, beginnen die Erkennungsmittel EKM mit der Berechnung der Krümmung KRU. Der Zeitpunkt tₖᵣ und der Spannungswert Uₖᵣ sind dabei so gewählt, daß für jede x-beliebige Entladespannungskurve ESK des Akkumulators AKK auf jeden Fall das "Spannungsknie" der Entladespannungskurve ESK durch die Krümmungsberechnung ausgewertet werden kann. Man ist deshalb bestrebt, den Startzeitpunkt für die Berechnung der Krümmung KRU der Entladespannungskurve ESK so dicht wie möglich an den Ort der Entladespannungskurve ESK zu legen, an dem das "Spannungsknie" einsetzt. Dies hat den Vorteil, daß die Berechnung nicht unnötigerweise schon vor dem eigentlich interessierenden Spannungsbereich durchgeführt wird.

Mit dem Unterschreiten des kritischen Spannungswertes Uₖᵣ wird der auszuwertende Spannungsbereich der Entladespannungskurve ESK für eine bessere Auswertung der Entladezustände des Akkumulators AKK durch die Spreizeinrichtung SPE in bezug auf die Spannungswerte gespreizt. Daran anschließend wird in der Mittelungseinrichtung MTE eine Analog/Digital-Mittelung durchgeführt. Das Ermittlungsmodul EMM der Steuerungseinrichtung STE ermittelt danach Ist-Krümmungswerte IKW, die es an das Vergleichsmodul VGM übergibt. Dem Vergleichsmodul VGM wird weiterhin ein in dem Speicher SP gespeicherter Soll-Krümmungswert SKW zugeführt, so daß das Vergleichsmodul VGM die beiden Krümmungswerte IKW, SKW miteinander vergleichen kann.

Liegt der Ist-Krümmungswert IKW bei diesem Vergleich über/unter dem Soll-Krümmungswert SKW, so wird durch die Anzeigesteuerung AZS über die BOF-Schnittstelle BSS die Anzeigeeinrichtung AE zum Anzeigen des Zustands "Akkumulator erschöpft" aktiviert. Mit der Anzeige des Zustands "Akkumulator erschöpft" an der Anzeigeeinrichtung AE wird die Berechnung der Krümmung abgebrochen. Das Schnurlos-Mobilteil MTₘₑ weist in diesem Fall unabhängig von dem verwendeten Typ des Akkumulators AKK und damit unabhängig von der jeweilgen Entladespannungskurve ESK eine immer annähernd gleiche Restbetriebszeit RBZ auf.

Liegt der Ist-Krümmungswert IKW bei diesem Vergleich unter/über dem Soll-Krümmungswert SKW, so wird die Berechnung der Krümmung solange weitergeführt bis der Ist-Krümmungswert IKW über/unter dem Soll-Krümmungswert SKW liegt.

## Patentansprüche

1. Verfahren zum Anzeigen des Zustands "Energiespeicher erschöpft" in Elektro-Geräten mit Elektro-Energiespeichern, mit folgenden Verfahrensschritten:
(a) Während der Entladephase des Elektro-Energiespeichers (AKK) wird eine die Krümmung einer Entladekurve (ESK) des Energiespeichers (AKK) angebende Kenngröße (KRU) in Form eines krümmungsbezogenen Istwertes (IKW) ermittelt,
(b) die Kenngröße (KRU) wird durch lineare Regression ermittelt,
(c) Definieren eines krümmungsbezogenen Sollwertes (SKW),
(d) Vergleichen des Istwertes (IKW) mit dem Sollwert (SKW),
(e) Anzeigen des Zustands "Energiespeicher erschöpft", wenn der Istwert (IKW) den Sollwert (SKW) unter-/überschreitet.

2. Verfahren nach Anspruch 1, **dadurch gekennzeichnet, daß** die Kenngröße (KRU) kontinuierlich in regelmäßigen Zeitabständen ermittelt wird.

3. Verfahren nach Anspruch 1 oder 2, **dadurch gekennzeichnet, daß** die Kenngröße (KRU) beim Unterschreiten eines vorgegebenen Entladekurvenwertes (Uₖᵣ) ermittelt wird, wobei der Entladekurvenwert (Uₖᵣ) derart vorgegeben wird, daß ein Zeitpunkt (tₖᵣ), an dem der Entladekurvenwert (Uₖᵣ) unterschritten wird, in der Nähe des Zeitpunktes liegt, bei dem ein "Spannungsknie" der Entladekurve (ESK) einsetzt.

4. Verwendung des Verfahrens nach einem der Ansprüche 1 bis 3 in einem Elektro-Gerät mit einem Akkumulator (AKK) als Elektro-Energiespeicher.

5. Verwendung des Verfahrens nach einem der Ansprüche 1 bis 3 in einem Elektro-Gerät mit einer Batterie als Elektro-Energiespeicher.

6. Verwendung des Verfahrens nach einem der Ansprüche 1 bis 5 in einem Schnurlos-Mobilteil (MTₘₑ).

7. Elektro-Gerät mit einem Elektro-Energiespeicher zum Anzeigen des Zustands "Energiespeicher erschöpft" mit folgenden Merkmalen:
(a) ersten Mitteln (SPE, MTE, EMM) zum Ermitteln von Daten, die während der Entladephase des Elektro-Energiespeichers (AKK eine die Krümmung einer Entladekurve (ESK) des Energiespeichers (AKK) angebende Kenngröße (KRU) in Form eines krümmungsbezogenen Istwertes (IKW) ermitteln,
(b) die ersten Mittel (SPE, MTE, EMM) sind derart ausgebildet, daß die Kenngröße (KRU) durch lineare Regression ermittelt wird,
(c) einem Speicher (SP), in dem ein vorgegebener, krümmungsbezogener Sollwert (SKW) gespeichert ist,
(d) zweiten Mitteln (VGM) zum Vergleichen von Daten, die mit. den ersten Mitteln (EMM) und dem Speicher (SP) verbunden sind und die den Istwert (IKW) mit dem Sollwert (SKW) vergleichen,
(e) dritten Mitteln (AZS) zum Anzeigen von Daten, die mit den zweiten Mitteln (VGM) und einer Anzeigeeinrichtung (AE) verbunden sind und die den Zustand "Energiespeicher erschöpft" dann anzeigen, wenn der Istwert (IKW) den Sollwert (SKW) unter-/überschreitet.

8. Elektro-Gerät nach Anspruch 7, **dadurch gekennzeichnet, daß** die ersten bis dritten Mittel (SPE, MTE, EMM, VGM, AZS) und der Speicher (SP) in einem Mikrocontroller (ZS, µC) integriert und implementiert sind.

9. Elektro-Gerät nach Anspruch 7 oder 8, **dadurch gekennzeichnet, daß** die ersten Mittel (SPE, MTE, EMM) derart ausgebildet sind, daß die Kenngröße (KRU) kontinuierlich in regelmäßigen Zeitabständen ermittelt wird.

10. Elektro-Gerät nach einem der Ansprüche 7 bis 9, **dadurch gekennzeichnet, daß** die ersten Mittel (SPE, MTE, EMM) derart ausgebildet sind, daß die Kenngröße (KRU) beim Unterschreiten eines vorgegebenen Entladekurvenwertes (Uₖᵣ) ermittelt wird, wobei der Entladekurvenwert (Uₖᵣ) derart vorgegeben wird, daß ein Zeitpunkt (tₖᵣ), an dem der Entladekurvenwert (Uₖᵣ) unterschritten wird, in der Nähe des Zeitpunktes liegt, bei dem ein "Spannungsknie" der Entladekurve (ESK) einsetzt.

11. Elektro-Gerät nach einem der Ansprüche 7 bis 10, **dadurch gekennzeichnet, daß** der Elektro-Energiespeicher als Akkumulator (AKK) ausgebildet ist.

12. Elektro-Gerät nach einem der Ansprüche 7 bis 10, **dadurch gekennzeichnet, daß** der Elektro-Energiespeicher als Batterie ausgebildet ist.

13. Elektro-Gerät nach einem der Ansprüche 7 bis 12, **dadurch gekennzeichnet, daß** das Elektro-Gerät ein Schnurlos-Mobilteil (MTₘₑ) ist.

## Claims

1. A method for indicating "low energy store" state in electrical devices having electrical energy stores, with the following method steps:
(a) during the discharge phase of the electrical energy store (AKK), a characteristic variable (KRU) which indicates the curvature of a discharge curve (ESK) of the energy store (AKK) is determined in the form of a curvature-related actual value (IKW),
(b) the characteristic variable (KRU) is determined by linear regression,
(c) definition of a curvature-related nominal value (SKW),
(d) comparison of the actual value (IKW) with the nominal value (SKW),
(e) indication of the "low energy store" state if the actual value (IKW) is less than/greater than the nominal value (SKW).

2. Method according to Claim 1, **characterized in that** the characteristic variable (KRW) is continually determined at regular time intervals.

3. Method according to Claim 1 or 2, **characterized in that** the characteristic variable (KRU) is determined when a specified discharge curve value (Uₖᵣ) is undershot, the discharge curve value (Uₖᵣ) being specified in such a manner that a time (tₖᵣ) at which the discharge curve value (Uₖᵣ) is undershot is in the vicinity of the time at which a "voltage knee" occurs in the discharge curve (ESK).

4. Use of the method according to one of Claims 1 to 3 in an electrical device having a rechargeable battery (AKK) as the electrical energy store.

5. Use of the method according to one of Claims 1 to 3 in an electrical device having a battery as the electrical energy store.

6. Use of the method according to one of Claims 1 to 5 in a cordless mobile part (MTₘₑ).

7. Electrical device having an electrical energy store for indicating the "low energy store" state, with the following features:
(a) first means (SPE, MTE, EMM) for determining data which, during the discharge phase of the electrical energy store (AKK), determine a characteristic variable (KRU) which indicates the curvature of a discharge curve (ESK) of the energy store (AKK) in the form of a curvature-related actual value (IKW),
(b) the first means (SPE, MTE, EMM) are designed in such a manner that the characteristic variable (KRU) is determined by linear regression,
(c) a memory (SP) in which a specified, curvature-related nominal value (SKW) is stored,
(d) second means (VGM) for comparison of data, which are connected to the first means (EMM) and to the memory (SP) and compare the actual value (IKW) with the nominal value (SKW),
(e) third means (AZS) for indicating data, which are connected to the second means (VGM) and to an indicating device (AE) and which indicate the "low energy store" state whenever the actual value (IKW) is less than/greater than the nominal value (SKW).

8. Electrical device according to Claim 7, **characterized in that** the first to third means (SPE, MTE, EMM, VGM, AZS) and the memory (SP) are integrated and implemented in a microcontroller (ZS, µC).

9. Electrical device according to Claim 7 or 8, **characterized in that** the first means (SPE, MTE, EMM) are designed in such a manner that the characteristic variable (KRU) is continually determined at regular time intervals.

10. Electrical device according to one of Claims 7 to 9, **characterized in that** the first means (SPE, MTE, EMM) are designed in such a manner that the characteristic variable (KRU) is determined when a predetermined discharge curve value (Uₖᵣ) is undershot, the discharge curve value (Uₖᵣ) being specified in such a manner that a time (tₖᵣ) at which the discharge curve value (Uₖᵣ) is undershot is in the vicinity of the time at which a "voltage knee" occurs in the discharge curve (ESK).

11. Electrical device according to one of Claims 7 to 10, **characterized in that** the electrical energy store is designed as a rechargeable battery (AKK).

12. Electrical device according to one of Claims 7 to 10, **characterized in that** the electrical energy store is designed as a battery.

13. Electrical device according to one of Claims 7 to 12, **characterized in that** the electrical device is a cordless mobile part (MTₘₑ).

## Revendications

1. Procédé d'affichage de l'état "Accumulateur d'énergie à plat" dans des appareils électriques pourvus d'accumulateurs d'énergie électrique, comprenant les étapes suivantes :
(a) pendant la phase de décharge de l'accumulateur d'énergie électrique (AKK), une grandeur caractéristique (KRU) indiquant la courbure d'une courbe dé décharge (ESK) de l'accumulateur d'énergie (AKK) est déterminée sous la forme d'une valeur effective (IKW) relative à la courbure,
(b) la grandeur caractéristique (KRU) est déterminée par régression linéaire,
(c) définition d'une valeur théorique (SKW) relative à la courbure,
(d) comparaison de la valeur effective (IKW) avec la valeur théorique (SKW),
(e) affichage de l'état "Accumulateur d'énergie à plat" si la valeur effective (IKW) est au-dessous/au-dessus de la valeur théorique (SKW).

2. Procédé selon la revendication 1, **caractérisé en ce que** la grandeur caractéristique (KRU) est déterminée continûment à intervalles de temps réguliers.

3. Procédé selon la revendication 1 ou 2, **caractérisé en ce que** la grandeur caractéristique (KRU) est déterminée lorsqu'elle passe au-dessous d'une valeur de courbe de décharge (Uₖᵣ) prédéfinie, ladite valeur de courbe de décharge (Uₖᵣ) étant prédéfinie de telle sorte qu'un instant (tₖᵣ) auquel la valeur de courbe de décharge (Uₖᵣ) n'est pas atteinte, se situe proche de l'instant auquel débute un "coude de tension" de la courbe de décharge (ESK).

4. Utilisation du procédé selon l'une des revendications 1 à 3 dans un appareil électrique pourvu d'un accumulateur (AKK) comme accumulateur d'énergie électrique.

5. Utilisation du procédé selon l'une des revendications 1 à 3 dans un appareil électrique pourvu d'une batterie comme accumulateur d'énergie électrique.

6. Utilisation du procédé selon l'une des revendications 1 à 5 dans une partie mobile sans fil (MTₘₑ).

7. Appareil électrique pourvu d'un accumulateur d'énergie électrique pour l'affichage de l'état "Accumulateur d'énergie à plat" ayant les caractéristiques suivantes :
(a) des premiers moyens (SPE, MTE, EMM) de détermination de données qui, pendant la phase de décharge de l'accumulateur d'énergie électrique (AKK), déterminent une grandeur caractéristique (KRU) indiquant la courbure d'une courbe de décharge (ESK) de l'accumulateur d'énergie (AKK) sous la forme d'une valeur effective (IKW) relative à la courbure,
(b) les premiers moyens (SPE, MTE, EMM) sont conçus de manière à déterminer la grandeur caractéristique (KRU) par régression linéaire,
(c) une mémoire (SP) dans laquelle est mémorisée une valeur théorique (SKW) prédéfinie relative à la courbure,
(d) des deuxièmes moyens (VGM) de comparaison de données, qui communiquent avec les premiers moyens (EMM) et la mémoire (SP) et qui comparent la valeur effective (IKW) avec la valeur théorique (SKW),
(e) des troisièmes moyens (AZS) d'affichage de données, qui communiquent avec les deuxièmes moyens (VGM) et un dispositif d'affichage (AE) et qui affichent l'état "Accumulateur d'énergie à plat" lorsque la valeur effective (IKW) est au-dessous/au-dessus de la valeur théorique (SKW).

8. Appareil électrique selon la revendication 7, **caractérisé en ce que** les premiers aux troisièmes moyens (SPE, MTE, EMM, VGM, AZS) et la mémoire (SP) sont intégrés et implémentés dans un microcontrôleur (ZS, µC).

9. Appareil électrique selon la revendication 7 ou 8, **caractérisé en ce que** les premiers moyens (SPE, MTE, EMM) sont conçus de manière à déterminer la grandeur caractéristique (KRU) continûment à intervalles de temps réguliers.

10. Appareil électrique selon l'une des revendications 7 à 9, **caractérisé en ce que** les premiers moyens (SPE, MTE, EMM) sont conçus de manière à déterminer la grandeur caractéristique (KRU) lorsqu'elle passe au-dessous d'une valeur de courbe de décharge (Uₖᵣ) prédéfinie, ladite valeur de courbe de décharge (Uₖᵣ) étant prédéfinie de telle sorte qu'un instant (tₖᵣ) auquel la valeur de courbe de décharge (Uₖᵣ) n'est pas atteinte, se situe proche de l'instant auquel débute un "coude de tension" de la courbe de décharge (ESK).

11. Appareil électrique selon l'une des revendications 7 à 10, **caractérisé en ce que** l'accumulateur d'énergie électrique est conçu comme accumulateur (AKK).

12. Appareil électrique selon l'une des revendications 7 à 10, **caractérisé en ce que** l'accumulateur d'énergie électrique est conçu comme batterie.

13. Appareil électrique selon l'une des revendications 7 à 12, **caractérisé en ce que** l'appareil électrique est une partie mobile sans fil (MTₘₑ).
